Europäisches Patentamt

European Patent Office

Office européen des brevets

(19)

(11) Publication number: 0 494 313 A1

# EUROPEAN PATENT APPLICATION
## published in accordance with Art. 158(3) EPC

(21) Application number: 91913105.2

(22) Date of filing: 24.07.91

(86) International application number:
PCT/JP91/00992

(87) International publication number:
WO 92/02050 (06.02.92 92/04)

(51) Int. Cl.5: H01L 27/115

(30) Priority: 24.07.90 JP 195857/90
05.07.91 JP 165553/91
11.07.91 JP 171123/91

(43) Date of publication of application:
15.07.92 Bulletin 92/29

(84) Designated Contracting States:
DE FR GB IT NL

(71) Applicant: SEIKO EPSON CORPORATION
4-1, Nishishinjuku 2-chome
Shinjuku-ku Tokyo 163(JP)

(72) Inventor: TAKENAKA, Kazuhiro
3-5, Owa 3-chome
Suwa-shi, Nagano-ken 392(JP)
Inventor: FUJISAWA, Akira
3-5, Owa 3-chome
Suwa-shi, Nagano-ken 392(JP)

(74) Representative: Ouinterno, Giuseppe et al
c/o Jacobacci-Casetta & Perani S.p.A. Via
Alfieri, 17
I-10121 Torino(IT)

(54) SEMICONDUCTOR DEVICE PROVIDED WITH FERROELECTRIC MATERIAL.

(57) A structure of a ferroelectric capacitor C exists on a source region (23) between a gate electrode (22) and a local oxide film (26). The capacitor C has a ferroelectric film (29) which is sandwiched between an upper electrode (30) and a lower electrode (31), and is provided with a conductive film (32) for preventing a reaction between the lower electrode (31) and the source region (23). The film (32) is made of TiN, TiON, TiW or MoSi. Even if, for the purpose of changing the crystalline quality of the ferroelectric film (29), it is subjected to an oxygen annealing treatment aftr formimg the film (29), oxygen is blocked with the conductive film. Therefore, no silicon oxide film is formed on the interface between the source and the capacitor C, and the reduction of a contact resistance and the avoidance of a serial parasitic capacitance can be attained. Thereby, the degree of freedom of the region for forming the capacitor C is increased, and a large scale integrated circuit can be realized.

FIG. 1

EP 0 494 313 A1

## Technical Field

The invention relates to a semiconductor device having ferroelectric such as a ferroelectric capacitor and the like applicable to a non-volatile memory and the like.

## Background Art

A non-volatile memory with the use of a ferroelectric which polarization is reversible by positive and reversed polarities of an applied voltage is theoretically equal in information write-in time and information read-out time. Moreover, even in stand-by condition (backup time) with no voltage, polarization (residual polarization) is maintained, a non-volatile memory is ideally promising.

Hitherto, as a semiconductor non-volatile memory having a ferroelectric capacitor, U.S. Patent 4,149,302 proposes a structure laminating a ferroelectric capacitor on a silicon (Si) substrate, and U.S. Patent 3,832,700 proposes a structure of arranging a ferroelectric film on a gate electrode of an MIS-type transistor.

## Problem to be solved by the Invention

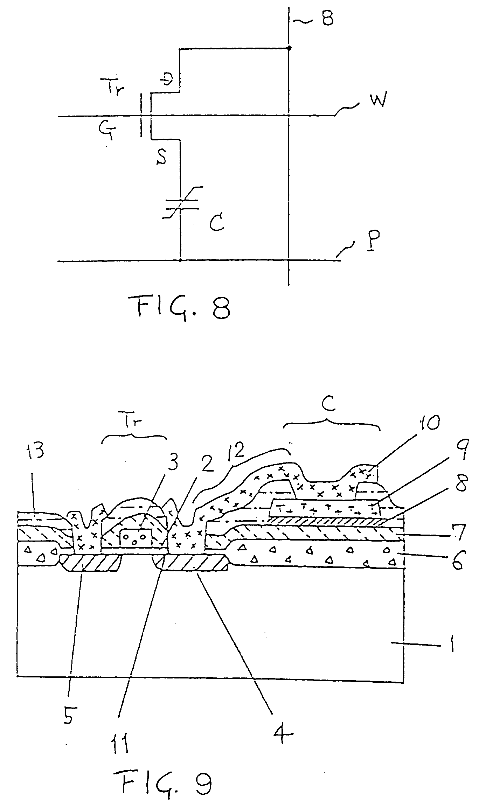

A non-volatile memory cell generally has a circuit construction comprising an N-type transistor Tr having a gate electrode G connected to a word line W, a drain electrode D connected to a bit line B and a source electrode S connected to one electrode of a ferroelectric capacitor C, and another electrode of the ferroelectric capacitor C connected to a plate line P as shown in Fig. 8. As an actual semiconductor structure of such memory cell, the one shown in Fig. 9 is recently proposed. The semiconductor structure shown in Fig. 9 comprises an N-type MOS transistor Tr consisting of a polysilicon gate electrode 3 formed via a gate oxide film 2 on a P-type silicone substrate 1, a high concentration N-type source region 4 and a drain region 5 diffused and formed in the silicon substrate 1 by self alignment, and a ferroelectric capacitor c formed on an interlayer insulating film 7 such as phosphorus glass and the like on a local oxide film (LOCOS) for separating element, and the ferroelectric capacitor C on the interlayer insulating layer 7 successively laminating a lower electrode 8 such as platinum (Pt), a ferroelectric film 9 such as PZT and an upper electrode 10 such as aluminum (Al). Moreover, the source region as a high concentration diffusion region and the upper electrode 10 are connected to each other with an Al wiring 12 via a contact hole 11. Furthermore, 12 is a second interlayer insulating film such as phosphorous glass.

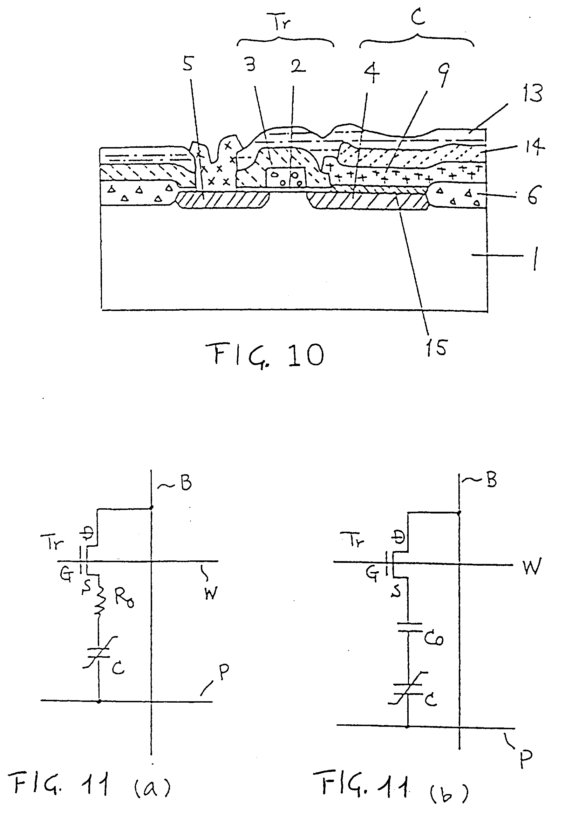

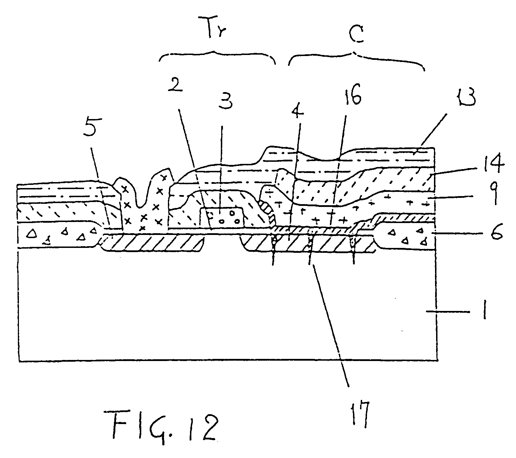

In the structure of forming the ferroelectric capacitor C via the interlayer insulating film 7 on the local oxide film 6, the ferroelectric capacitor C is formed by effectively utilizing a space on the local oxide film 6, but lengths of the wiring 12 from the source region 11 to the upper electrode 10 and from the upper electrode 10 to the plate line P are redundant to invite increase of a memory cell occupied area. However, the memory cell of this structure invites increase of a cell area, but a realistic structure for the following reason. That is, the inventor in trial manufactured a memory cell structure directly depositing a ferroelectric film 9 on a source region 4 as shown in Fig. 10. An upper electrode wiring 14 of polysilicon was formed on the ferroelectric film 9, and the source region 4 was used as a lower electrode. However, after the ferroelectric film 9 is formed, an oxygen annealing treatment is necessary for increasing a relative dielectric constant Es by improving crystallization of the film. Because of strong reactivity of oxygen in an oxygen annealing treatment step, a silicon oxide film $(SiO_2)$ 15 is inevitably formed between the source region 4 and the ferroelectric film 9. When a film thickness of this film 15 is very thin, as shown in Fig. 11(a), the silicon oxide film 15 becomes a series contact resistance $R_0$. The existence of this parasitic contact resistance $R_0$ brings about a lag of the access speed. Moreover, when the film 15 is comparatively thick, as shown in Fig. 11(b), the film 15 becomes a series parasitic capacitor CO. In such a case, the memory capacitance of a memory cell is a series synthetic capacitance of the parasitic capacitor CO and the ferroelectric capacitor C. However, therefore, a partial potential of the source voltage is applied to the parasitic capacitor CO. In order to prevent dielectric breakdown of the silicon oxide film 15 by the partial potential, it is necessary to make considerably thick the film thickness or to control the partial potential per se. If the silicon oxide film 15 is made considerably thick, its partial potential becomes inevitably high, so as to be hardly effective for improving withstanding voltage. In order to directly control the partial potential, it is necessary to make the silicon oxide film 15 very thin, or to make the ferroelectric film 9 considerably thick. The very thin silicon oxide film 15 is impossible owing to the above-described oxygen annealing treatment, and the considerably thick ferroelectric film 9 means to lower capacitance of the ferroelectric capacitor C, so that a function of the ferroelectric capacitor cannot be exhibited.

Aiming the reform crystallizability of a ferroelectric film in case of annealing, the inventor manufactured a memory cell structure with the use of Pt as a lower electrode 16 as shown in Fig. 12 for trial. As described above, after the ferroelectric film 9 is formed, an oxygen annealing treatment is required, but in case of using Pt for the lower electrode, because of strong reactivity of Pt with Si, there is generated a spike-like reaction 17 of Pt with Si as shown in Fig. 12, the region 17 exceeds a diffusion joint region to generate a joint leak, and to interfere with the action of a memory cell frequently.

For the above reason, the structure shown in Fig. 8 is a useful structure as a non-volatile memory structure by sufficiently performing a function of a ferroelectric. However, the structure still has a problem such as a large cell area as described above.

By taking the above problems of each structure into consideration, the invention provides a semiconductor device provided with a ferroelectric of the structure without inviting increase of a plate space accompanied to formation a ferroelectric capacitor or reduction of a cell area without spoiling the function as a non-volatile memory with the use of a ferroelectric.

Disclosure of the Invention

The invention basically provides a formation structure of a ferroelectric on the main surface or inside of a semiconductor substrate or semiconductor basic plate. As a typical semiconductor substrate, there is a silicon substrate, but a compound semiconductor such as gallium, arsenic and the like can also be applied to an oxygen-combined substrate. A region of the ferroelectric formation structure may be an intrinsic semiconductor region, and may preferably be an N-type or P-type region of an impurity diffusion region. As the impurity diffusion region, typical examples are a source region or drain region of an MIS-type transistor and a diffusion region and the like of three electrodes of a bipolar transistor, but it is possible to materialize a ferroelectric formation structure or not limited only to the active region of an active element but also to each region of a passive element such as a diffusion resistance layer, stopper region and the like. A ferroelectric capacitor structure can naturally be materialized by accumulating on a diffusion region, and can be materialized within a trench. That is, means provided by the invention lies in the point of employing a conductive reaction preventive film sandwiching structure between a semiconductor substrate and a ferroelectric electrode. That is, the invention employs a laminated structure of a semiconductor substrate, a conductive reaction preventive film, an electrode and a ferroelectric film in this order. As the ferroelectric film, use is generally made of $PbTiO_3$, PZT ($PbTiO_3$, $PbZrO_3$) or PLZT (La, $PbTiO_3$, $PbZrO_3$). A ferroelectric film of this kind is formed by a sputtering method for instance, and thereafter required an oxygen annealing treatment for improving a dielectric constant. As the electrode adjacent to the ferroelectric film, use is made of Pt or Pd, and preferably Pt which lattice constant is close to that of the ferroelectric film.

The conductive reaction preventive film may be any one of TiN film, TiW film and MoSi film, or mixed film of more than two of them for instance. The structure sandwiching such conductive reaction preventive film between the semiconductor substrate and the electrode prevents oxygen from diffusing to the interface of the semiconductor substrate in the above oxygen annealing treatment, and checks the generation of an oxide film on the interface. Therefore, it is not necessary to provide a ferroelectric element on LOCOS of a semiconductor substrate, a degree of freedom of the formation region is enlarged and contributed to high density integration.

As second means of the invention, it is preferable to interpose a conductive reaction preventive film formable conductive metal film between the semiconductor substrate and the above-described conductive reaction preventive film. This conductive metal film may be a metal film which cannot form a conductive reaction preventive film. As described above, the conductive reaction preventive film *per se* is conductive and oxygen blocking. However, it is desirable to use conductive metal which can form said conductive reaction preventive film. Because its oxygen blocking ability is fully maintained and any process addition is excluded. As the conductive metal film, use is made of any one of Ti film, W film and Mo film, or a mixed film of more than two of them. In order to aim at further reduction of contact resistance, it is preferable to form a metal silicide film on the interface of the semiconductor substrate. As the metal silicide film, use is made of a silicide film consisting essentially of any metal of Ti, W, and Mo.

According to the structure of the semiconductor device of the invention, diffusion of oxygen to the semiconductor substrate interface can be prevented in case of oxygen annealing treatment by employing the laminated structure of a semiconductor substrate, a conductive reaction preventive film, an electrode and a ferroelectric film in this order, so as to prevent forming of a silicon oxide film. Moreover, a reaction of an electrode and a semiconductor substrate can be prevented, so that there is generated no leak current in diffusion connection.

Brief Description of the Drawings

Fig. 1 is an essential cross section of Embodiment 1 of the invention.

Fig. 2 is an essential cross section of Embodiment 2 of the invention.

Figs. 3(a), (b) and (c) are cross sections showing a manufacturing process of Embodiment 2 of the invention.

Fig. 4 is an essential cross section showing another structure of Embodiment 2.

Fig. 5 is an essential cross section of Embodiment 3 of the invention.

Fig. 6 is an essential cross section of a modified example of Embodiment 3 of the invention.

Fig. 7 is an essential cross section of another modified example of Embodiment 3 of the invention.

Fig. 8 is a circuit diagram showing a non-volatile memory.

Fig. 9 is an essential cross section showing a semiconductor device provided with a ferroelectric capacitor of a prior art.

Fig. 10 is an essential cross section showing another example of the semiconductor device provided with the ferroelectric capacitor of the prior art.

Figs. 11(a) and (b) are circuit diagram showing equivalent circuits of a non-volatile memory cell of the semiconductor structure relating to the above example.

Fig. 12 is an essential cross section showing a further example of the semiconductor device provided with the ferroelectric capacitor of the prior art.

Best Mode for carrying out the Invention

Embodiments of the invention will be explained referring to the accompanying drawings.

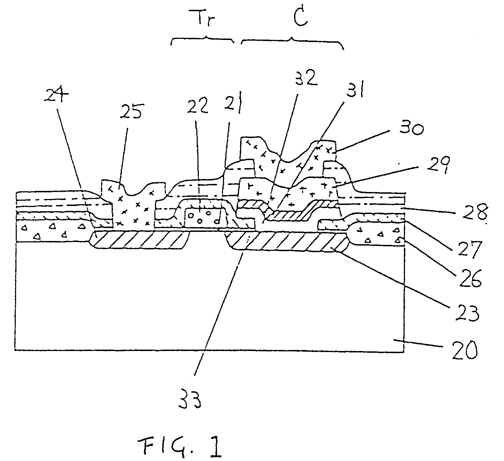

Fig. 1 is an essential cross section showing Embodiment 1 of a semiconductor device provided with a ferroelectric capacitor according to the invention.

This semiconductor device is a non-volatile memory having a memory cell of an equivalent circuit shown in Fig. 8. This embodiment uses a P-type silicon substrate 20 as a wafer having specific resistance of 20 $\Omega$cm for instance, on which is formed a structure of an N-type MOS transistor Tr and a ferroelectric capacitor C. As known, the semiconductor structure of an N-type MOS transistor Tr comprises a gate electrode 22 of phosphorus doped polysilicon formed via a gate insulating film (silicon oxide film) 21 on a silicon substrate 20, a source region 23 and a drain region 24 as high concentration N-type impurity diffusion regions within the substrate formed by ion implanting phosphorus at 80 KV, 5E15 cm$^{-2}$ by self-aligning with the use of the gate electrode 22 as a mask. To the drain region 24 is connected a wiring electrode 25 of Al formed by a sputtering method via a contact hole. 26 is a local oxide film (LOCOS) of about 60 nm in thickness for separating an element. 27 is a first interlayer insulating film, and 28 is a second interlayer insulating film of phosphorus glass having a thickness of about 40 nm by vapor phase growth method for instance.

In the present embodiment, there is provided a structure of the ferroelectric capacitor C as a ferroelectric formation structure on the source region 23 between the gate electrode 23 and the local oxide film 26. This structure comprises the ferroelectric film 28 as a fundamental structure and an upper electrode 30 and a lower electrode 31 as electrode layers sandwiching the ferroelectric film 28, and provided with a conductive reaction preventive film 32 between the lower electrode 31 and the source region 23. As the ferroelectric film 29, use is made of $PbTiO_3$, PZT ($PbTiO_3$, $PbZrO_3$) or PLZT (La, $PbTiO_3$, $PbZrO_3$) formed by a sputtering method for instance. As the upper electrode, use is made of aluminum (Al) of low specific resistance for instance formed by a deposition method or a sputtering method. As the lower electrode 31, use is made of platinum (Pt) or palladium (Pd) for instance formed by a sputtering method. In case of selecting platinum (Pt) as the lower electrode 31, a lattice constant thereof is near to that of $PbTiO_3$, PZT or PLZT of the ferroelectric film 29, so that crystallizability is reformed simultaneously with an oxygen annealing treatment of the ferroelectric film 29, and good electrical characteristics can be obtained. The conductive reaction preventive film 32 sandwiched between the active region and the lower electrode is a TiN film, TiON film, TiW film, MoSi film and the like formed by a sputtering method for instance. This conductive reaction preventive film is conductively contacted with the high concentrated N-type source region 23 at a contact hole 33 bored in the first interlayer insulating film 27 of phosphorus glass.

As a method for forming such ferroelectric capacitor C, first, the first interlayer insulating film 27 coated on the source region 23 is bored, a conductive reaction preventive layer is deposited by a sputtering method to form the conductive reaction preventive film 32 on the bored window, the lower electrode 31 and the ferroelectric film 29 are further laminated by a sputtering method, and thereafter the whole surface is coated with the second interlayer insulating film 28. Thereafter, the upper electrode 30, the wiring (plate wire) and the drain electrode wiring 25 are formed by photoetching technique as a prior art.

The ferroelectric capacitor C is thus laminated on the source region 23 via the conductive reaction preventive film 32. Therefore, a wiring plate occupied area between the source region 23 and the lower electrode 31 can effectively be accompanied so as to effectively reduce the cell area. Moreover, since no silicon oxide film is parasitic on the surface of the source region 23, a memory capacitor only by the ferroelectric capacitor C is realized.

In the above manufacturing process, after the ferroelectric film 29 is formed, a heat treatment (oxygen annealing treatment) is carried out in an oxygen-containing atmosphere. This is for reforming crystallizability of the ferroelectric film 29 and increasing dielectric constant Es to more than 1000 for instance. In this oxygen annealing treatment, oxygen enters into a grain boundary of the ferroelectric film 29 and the lower electrode 31. However, the conductive reaction preventive film 32 has property of blocking oxygen, so that formation of a silicon oxide film on the interface of the source electrode can be prevented. Moreover, in case of using a TiN film or a TiON film as the conductive reaction preventive film 32, the surface of the conductive reaction preventive film is oxidized to some extent, but reaction prevention is increased by some oxidation and these films are advantageous. In any case, a silicon oxide film is scarcely formed on the interface of the source region 23, and reduction of contact resistance or avoidance of series parasitic capacitance can be attained. In case of using platinum (Pt) for the lower electrode 31, as described above, crystallizability of the ferroelectric film 29 is reformed in oxygen annealing treatment, but reactivity of platinum and silicon (Si) is too strong to invites diffusion of Pt in the substrate. However, in case of the invention, diffusion can be prevented by the conductive reaction preventive film 32 interposed therebetween. Moreover, it is preferable to form metal silicide such as titanium (Ti) silicide film and the like between the conductive reaction preventive film 32 and the source region 23. Moreover, it is preferable to insert a Ti film and the like between the conductive reaction preventive film 32 and the lower electrode 31.

In the non-volatile memory having the prior ferroelectric capacitor design as shown in Fig. 9, information rewriting number in case of absence of the conductive reaction preventive film 32 ws 10E5 times because of no oxygen annealing at high temperature, but in case of using a TiN film as the conductive reaction preventive film in the present embodiment, information rewriting number reached 10E9 times because oxygen annealing at more than 500°C becomes possible. Moreover, as dielectric constant Es of the ferroelectric film, a value around 1500 was obtained.

An advantage for constructing the ferroelectric capacitor C of a longitudinally laminated structure on the source region 23 can not only reduce a cell area, but also reduce one electrode contact portion (contact resistance portion) as compared with the structure of Fig. 9. This is by a reason that the wiring 12 portion shown in Fig. 9 can essentially be eliminated. Therefore, the invention can contribute to shortening of information write-in • read-out time. As apparent from comparison of Figs. 1 and 9, an upper electrode 10 of Fig. 9 corresponds to the lower electrode 31 of the present embodiment, and a lower electrode 8 of Fig. 9 topologically corresponds to the upper electrode 30 of the present embodiment. As the lower electrode 31 in the present embodiment, it is preferable to select Pt, but Pt has large specific resistance as compared with Al. However, the lower electrode 31 of the present embodiment is thin in film thickness and larger than the contact area in contact hole, so that a resistance value between the source region 23 and the ferroelectric capacitor C is not a problem. Moreover, the upper electrode 30 as a plate wire P and its wiring can be formed with Al. That is, the plate wire P can be formed on the ferroelectric 29. Therefore, as compared with the prior art, an uneven plate potential by every cell can remarkably be improved. Moreover, the ferroelectric capacitor C has hitherto been longitudinally laminated on thick LOCOS and step difference drape of each film is a problem, but in the present embodiment, ferroelectric capacitors C are formed on both sides of the gate electrode 22 so as to improve step difference drops.

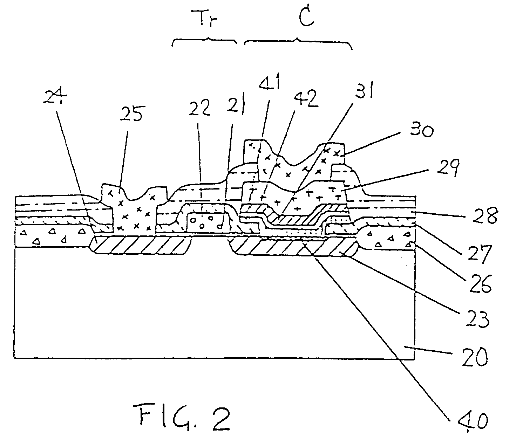

Fig. 2 is an essential cross section of Embodiment 2 of the semiconductor device provided with the ferroelectric capacitor according to the invention. Moreover, in Fig. 2, like parts shown in Fig. 1 are shown by like reference symbols and the explanation thereof is omitted. In this embodiment, a ferroelectric capacitor C is laminated on a source region 23. Between the source region 23 and a lower electrode 31 are successively laminated a metal silicide film 40, a conductive metal film 41 and a conductive reaction preventive film 42. As the conductive metal film 41, use is made of metal such as titanium (Ti) and this film having a conductivity. An underlayer of this conductive metal film 41 is a metal silicide film 40 consisting essentially of metal silicide of the same metal. Between the conductive metal film 41 and the lower electrode 30 is sandwiched a conductive reaction preventive film 42 such as titanium nitride (TiN), titanium oxinitride (TiON) and the like. The point different from Embodiment 1 is the presence of the metal silicide and the conductive metal film 41. The meaning of presence of the conductive metal film 41 such as titanium serve as an object for forming the metal silicide film 40 and at the same time as an object for forming the conductive reaction preventive film 42 such as titanium nitride (TiN), titanium oxinitride (TiON). The presence of the metal silicide film 40 reduces contact resistance.

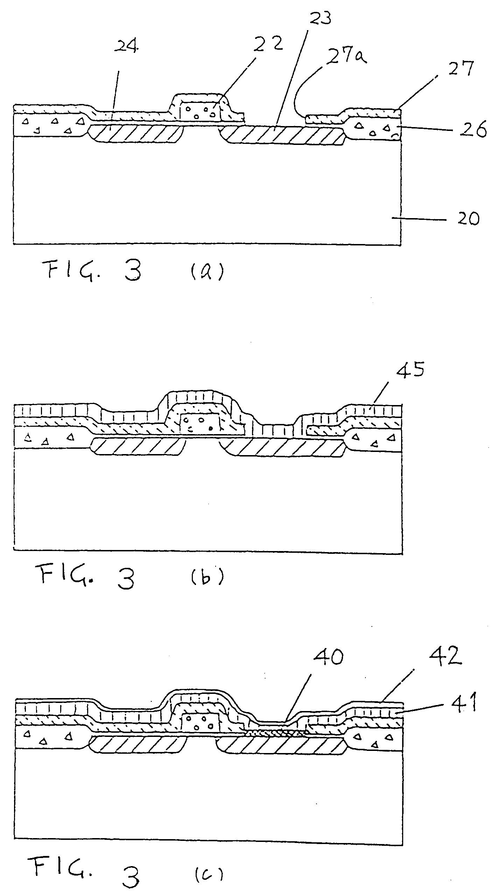

A manufacturing method of the above embodiment is explained referring to Fig. 3 hereinafter.

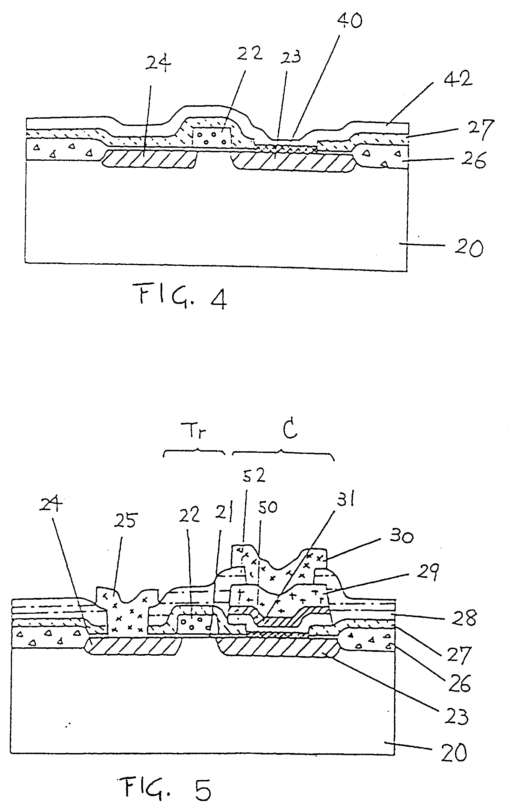

First, as shown in Fig. 3(a), after a gate electrode 22 is formed, a high concentration N-type source region 23 and a drain region 24 are formed within a P-type semiconductor substrate 20 by self-alignment. Second, phosphorus glass is coated on the whole surface to form a first interlayer insulating film 27. Third, the interlayer insulating film on the source region is etched to bore a contact hole 27a. Forth, as shown in Fig. 3(b), a titanium (Ti) film 45 as metal for forming a conductive reaction preventive film by a sputtering method for example is coated in thickness of 100 nm all over the surface. Thereafter, a heat treatment is applied in a nitrogen-containing atmosphere. By this heat treatment, as in Fig. 3(c), the surface side of a titanium (Ti) film 45 is nitrided, and a conductive reaction preventive film 42 of titanium nitride (TiN) is formed. Some oxygen is mixed in this annealing so as to be possible to form titanium oxinitride (TiON). Moreover, on the side contacted to the source region 23 of the titanium (Ti) film 42 is formed on a metal silicide film 40 consisting essentially of Ti. As a result of this annealing treatment, as shown in Fig. 4, it may be preferable to change the (upper surface side) surface side of the titanium (Ti) film to the conductive reaction preventive film 42 of titanium nitride (TiN) and the lower surface side (back side) thereof to the metal silicide film 40, respectively, or as shown in Fig. 3(c), it may be preferable to partly remain the conductive metal film 41 of titanium (Ti) as it is without change. The significance for directly depositing a metal film 45 for forming the conductive reaction preventive film on the source region 23 is functionally advantageous in process as compared with a method for forming a conductive reaction preventive film as in Embodiment 1. Self-formation of the metal silicide film 40 contributes to reduction of contact resistance, and an advantage of shortening access time can successfully be obtained in the manner of no additional process.

Fig. 5 is an essential cross section showing Embodiment 3 of a semiconductor device provided with a ferroelectric capacitor of the present invention. Moreover, in Fig. 5, like parts shown in Fig. 1 are shown by like reference symbols and the explanation thereof is omitted. In this embodiment, too, between a source region 23 and a lower electrode 31 are successively laminated a Ti silicide film 40 as a silicide film, and a conductive reaction preventive film 52. As the conductive reaction preventive film 52, use is made of TiN film, TiON film, TiW film, MoSi film and the like. Between the source region 23 and the conductive reaction preventive film 52 is sandwiched the Ti silicide film 50. This is for reducing contact resistance. As a method for forming a Ti silicide film, Ti is deposited into a thickness of 100 nm by a sputtering method, a contact hole is filled, thereafter heat treated at 700°C for 20 minutes in Ar atmosphere, thereby reacting Ti of the contact hole with Si of the source region 23 to form Ti silicide. Thereafter, non-reacted Ti is removed by a mixed solution of a hydrogen peroxide solution, ammonia water and water. A conductive reaction preventive film 52 is formed on the Ti silicide film 50 by a sputtering method for instance. As the silicide film 50, use may be made of Pt silicide and W silicide. Because an object of the silicide film is to reduce contact resistance. As a method of forming a Pt silicide film, Pt is deposited in a thickness of 100 nm by a sputtering method, a contact hole is filled, thereafter heat treated at 400°C for 20 minutes in Ar atmosphere, thereby reacting Pt of the contact hole with Si of the source region 23 to form Pt silicide. Thereafter, non-reacted Pt is moved by aqua regia.

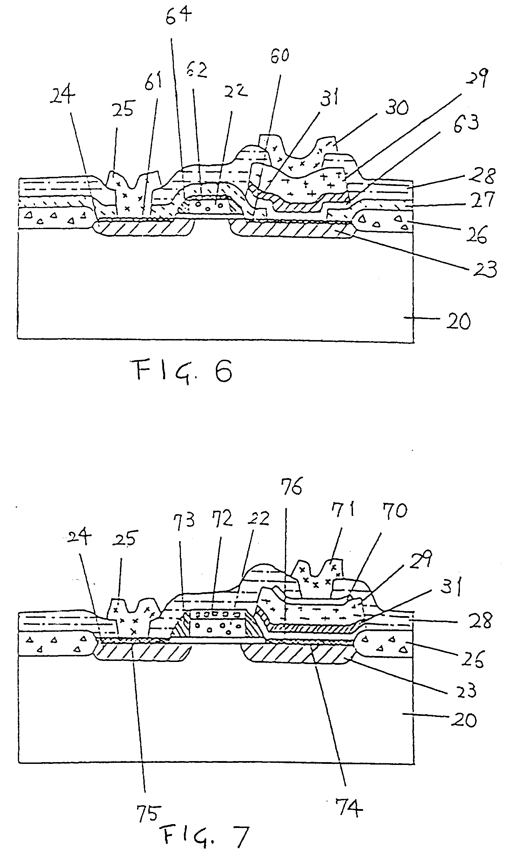

Fig. 6 is an essential cross section showing a modified example of the present embodiment of the semiconductor device. In the above embodiment, the Ti silicide film 50 is formed only with the contact hole, but in this modified embodiment, Ti silicides 60, 61 and 62 are formed on the source region 23, the gate electrode 22 and the drain region 24, respectively, by self aligned silicide (self-aligned metal silicide). 64 is a sidewall formed by an insulating film such as $SiO_2$ formed for forming self aligned silicide (self-aligned metal silicide). Contact resistance of the source contact portion can be reduced by employing the present invention to such process.

Fig. 7 is a main cross section showing another modified example of the present embodiment of the semiconductor device. In the above embodiment, the source region and the lower electrode or the conductive reaction preventive film are connected by the contact hole, but in this modified example, as in the embodiment of Fig. 6, a conductive reaction preventive film 76 is directly formed on Ti silicide 74 formed on the source region by self-aligned silicide. This is for preventing evenness of the capacitor portion from deteriorating by forming the contact hole. In this modified example, in order to prevent short circuit between the conductive reaction preventive film 76 and the gate electrode 22, an insulating film 72 is formed on the gate electrode 22, and the conductive reaction preventive film 76 and the gate electrode 22 are separated by a sidewall 73.

In embodiments up to Fig. 6, all the upper electrodes are wiring electrodes of Al, but it is preferable to form an upper electrode 70 with the use of Pt and to connect to the upper electrode by a wiring electrode as in the present embodiment. Moreover, in each of the above embodiments, a Ti silicide film is mainly formed, but silicide such as Mo, W, Pt, Pd, Ta and the like may be preferable.

As the formation structure of the above-described ferroelectric on a diffusion region or a substrate, a non-volatile memory is mainly explained, but it is naturally applied to a memory (DRAM) and the like with the aid of large dielectric constant, and also applied to an electric network which requires high capacity.

Industrial Applicability

As explained above, the semiconductor device provided with the ferroelectric according to the invention provides the formation construction of the ferroelectric on the main surface or inside of a silicon substrate. The invention can form a ferroelectric for a substrate having oxygen bonding properties.

The region of the ferroelectric formation structure may be an intrinsic semiconductor, and an N-type or P-type region of an impurity diffusion region. Typical examples are the source region or drain region of an MIS type transistor, bipolar, an impurity diffusion region of eight electrodes of a transistor and the like, but the ferroelectric formation structure can be materialized on not only the active region of an active element but also each region of a passive element such as a resistance diffusion layer, stopper region and the like. The case of materializing a ferroelectric capacitor structure laminating on the diffusion region is a matter of course, and a ferroelectric formation structure can be materialized within a trench. It is also suited to use in a non-volatile memory which is required to be high density integrated.

**Claims**

1. A semiconductor device provided with a ferroelectric formed on the main surface or inside of a semiconductor substrate having oxygen-bonding properties as an element factor, characterized in that between said semiconductor substrate and said electrode is formed a conductive reaction preventive film.

2. The semiconductor device provided with the ferroelectric as claimed in claim 1, wherein said conductive reaction preventive film is any one of a nitride Ti film, oxinitride Ti film, TiW film and MoSi film or their mixed film.

3. A semiconductor device provided with a ferroelectric formed on the main surface of inside of a semiconductor substrate having oxygen-bonding properties as an element factor, characterized in that between said semiconductor substrate and said element is formed a conductive reaction preventive film, and between said semiconductor substrate and said conductive reaction preventive film is formed a conductive metal film.

4. The semiconductor device provided with the ferroelectric as claimed in claim 3, wherein said conductive metal is a metal film which can form said conductive reaction preventive film.

5. The semiconductor device provided with the ferroelectric as claimed in claim 4, wherein said conductive metal is a Ti film.

6. A semiconductor device provided with a ferroelectric formed on the main surface or inside of a semiconductor substrate having oxygen-bonding properties as an element factor, characterized in that between said semiconductor substrate and said electrode is formed a conductive reaction preventing film, and on an interface of said semiconductor substrate is formed metal silicide.

7. The semiconductor device provided with the ferroelectric as claimed in claim 6, wherein said metal silicide is any one of TiSi, WSi, MoSi, PtSi, PdSi and TaSi.

FIG. 1

FIG. 2

FIG. 3    (a)

FIG. 3    (b)

FIG. 3    (c)

FIG. 4

FIG. 5

FIG. 6

FIG. 7

FIG. 8

FIG. 9

FIG. 10

FIG. 11 (a)

FIG. 11 (b)

FIG. 12

# INTERNATIONAL SEARCH REPORT

International Application No PCT/JP91/00992

## I. CLASSIFICATION OF SUBJECT MATTER (if several classification symbols apply, indicate all) 6

According to International Patent Classification (IPC) or to both National Classification and IPC

Int. Cl⁵  H01L27/115

## II. FIELDS SEARCHED

Minimum Documentation Searched 7

| Classification System | Classification Symbols |
|---|---|
| IPC | H01L27/115, 29/792, 29/46 |

Documentation Searched other than Minimum Documentation
to the Extent that such Documents are Included in the Fields Searched 8

| | |
|---|---|
| Jitsuyo Shinan Koho | 1970 - 1990 |
| Kokai Jitsuyo Shinan Koho | 1972 - 1990 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 1-251760 (Seiko Epson Corp.), October 6, 1989 (06. 10. 89), Line 13, upper right column to line 12, lower left column, page 2 | 1 |
| Y | JP, A, 2-183570 (Seiko Epson Corp.), July 18, 1990 (18. 07. 90), Lines 14 to 18, upper right column, page 2 | 1, 2 |
| P | JP, A, 2-288367 (Seiko Epson Corp.), November 28, 1990 (28. 11. 90), Line 16, lower right column, page 2 to line 2, upper left column, page 3, lines 9 to 20, lower left column, page 2 | 3, 4, 5, 6, 7 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 21, 1991 (21. 10. 91) | October 28, 1991 (28. 10. 91) |

| International Searching Authority | Signature of Authorized Officer |
|---|---|
| Japanese Patent Office | |

Form PCT/ISA/210 (second sheet) (January 1985)